# EUROPÄISCHE PATENTANMELDUNG

(11) **EP 4 632 346 A1**
(43) Veröffentlichungstag der Anmeldung: **15.10.2025**
(21) Anmeldenummer: 25169330.5
(22) Anmeldetag: 09.04.2025
(51) Int. Cl.: G01M 13/025, G01R 31/34, G01M 13/026

(54) **PRÜFVORRICHTUNG FÜR ELEKTRISCHE ANTRIEBSEINHEITEN**

(30) Priorität: 09.04.2024 DE 102024109887
(71) Anmelder: JW Froehlich Maschinenfabrik GmbH, 70771 Leinfelden-Echterdingen (DE)
(72) Erfinder: Maginski, Lucas, 71093 Weil im Schönbuch (DE); Bosch, Boris, 73349 Wiesensteig (DE); Strasser, Christoph, 73079 Süssen (DE); Dorenburg, Marco, 70567 Stuttgart (DE)
(74) Vertreter: DREISS Patentanwälte PartG mbB

(57) **Zusammenfassung**

Die Erfindung betrifft eine Prüfvorrichtung (10) für elektrische Antriebseinheiten umfassend eine Aufnahme (12a, b) für eine elektrischen Antriebseinheit (14) sowie zwei Abtriebswellen (16), die beidseits endseitig mit einer elektrischen Antriebseinheit (14) koppelbar sind, wobei die zwei Abtriebswellen (16) jeweils mit einem separaten Abtriebsmotor (20) gekoppelt sind, die die elektrischen Antriebseinheit (14) in einem motorischen Betrieb antreiben und/oder in einem generatorischen Betrieb belasten können, dadurch gekennzeichnet, dass jeder Abtriebsmotor (20) über ein Getriebe (22) mit der zugehörigen Abtriebswelle (16) gekoppelt ist.

## Beschreibung

Die Erfindung betrifft eine Prüfvorrichtung für elektrische Antriebseinheiten umfassend eine Aufnahme für eine elektrische Antriebseinheit (Electric Drive Unit (EDU)) sowie zwei Abtriebswellen, die beidseits endseitig mit der elektrischen Antriebseinheit koppelbar sind, wobei die zwei Abtriebswellen jeweils mit einem separaten Abtriebsmotor gekoppelt sind, die die elektrische Antriebseinheit in einem motorischen Betrieb antreiben und/oder in einem generatorischen Betrieb belasten können.

Eine elektrische Antriebseinheit ist die elektrifizierte Antriebseinheit zum mechanischen Antrieb eines Elektrofahrzeugs, bestehend unter anderem aus einem Elektromotor, Inverter, Getriebe, Differential und diverser Sensorik und Aktorik.

In einer klassischen Prüfvorrichtung für eine elektrische Antriebseinheit wird die elektrische Antriebseinheit über zwei Abtriebswellen mechanisch unmittelbar an zwei Abtriebsmotoren (links und rechts der elektrischen Antriebseinheit angeordnet) gekoppelt. Die Abtriebsmotoren dienen zur Simulation / Nachbildung der Räder und können die elektrische Antriebseinheit im generatorischen Betrieb belasten, aber auch im motorischen Betrieb antreiben (Nachbildung des Rekuperationsmodus). Die elektrische Antriebseinheit arbeitet entsprechend gegen diese Abtriebsmotoren.

Zur Qualitätsprüfung von elektrischen Antriebseinheiten ist es bekannt, dass diese in einer entsprechenden Prüfvorrichtung verschiedenen Tests und Messungen, z.B. zur Geräuschemission unterzogen werden. Diese Prüfvorrichtungen haben die Aufgabe, die Wertschöpfung innerhalb der Produktionslinie abzusichern und damit Fertigungs-, Montage- und Bauteilfehler zu identifizieren. Damit wird verhindert, dass fehlerhaft montierte bzw. nicht korrekt funktionierende elektrischen Antriebseinheiten in Elektrofahrzeuge verbaut und schlussendlich an den Endkunden ausgeliefert werden.

Für diese Qualitätsabsicherung werden üblicherweise sogenannte EOL-Prüfstände (EOL = End of Line) verwendet, welche am Ende der Produktionslinie stehen und die elektrischen Antriebseinheiten auf Funktion prüfen. Bei dieser Funktionsprüfung wird die elektrische Antriebseinheit innerhalb der Prüfvorrichtung betrieben, wodurch ein sehr fahrzeugnaher Betrieb realisiert wird.

Ein zentrales Qualitätskriterium von elektrischen Antriebseinheiten ist die NVH-Messung (NVH = Noise Vibration Harness), also der Körperschall der elektrischen Antriebseinheit im Betrieb. Ein Nachteil bei der NVH-Messung in einem üblichen Aufbau einer Prüfvorrichtung ist allerdings, dass über die starren Abtriebswellen und die direkte mechanische Verbindung der Abtriebsmotoren auch die Vibrationen der Abtriebsmotoren erfasst werden und in das Messergebnis der NVH-Sensorik eingehen. Damit wird nicht nur die elektrische Antriebseinheit alleine gemessen, sondern auch die Abtriebsmotoren.

Aufgabe der Erfindung ist es nun, die Prüfvorrichtung so zu gestalten, dass die Geräuschemissionen der Abtriebsmotoren besser herausselektiert werden können.

Die Erfindung löst diese Aufgabe durch eine Prüfvorrichtung mit den Merkmalen des Anspruchs 1. Vorteilhafte Weiterbildungen der Erfindung sind in den Unteransprüchen dargelegt.

Die Prüfvorrichtung für elektrische Antriebseinheiten umfasst dabei eine Aufnahme für eine elektrische Antriebseinheit sowie zwei Abtriebswellen, die beidseits endseitig mit der elektrischen Antriebseinheit koppelbar sind, wobei die zwei Abtriebswellen jeweils mit einem separaten Abtriebsmotor gekoppelt sind, die die elektrische Antriebseinheit in einem motorischen Betrieb antreiben und/oder in einem generatorischen Betrieb belasten können.

Dabei ist gegenüber dem Bekannten vorgesehen, dass jeder Abtriebsmotor über ein Getriebe mit der zugehörigen Abtriebswelle gekoppelt ist und die direkte Kopplung der Antriebseinheit mit dem Abtriebsmotor damit entfällt. Durch die Zwischenschaltung eines Getriebes, insbesondere nach einem ersten Ausführungsbeispiel eines Riemengetriebes, kann die akustische Beeinflussung einer Messung zur Sicherung der Qualität der elektrischen Antriebseinheit verbessert werden, da das Getriebe die Entkopplung der Akustik erlaubt. Auf diese Weise können Geräusche des Abtriebsmotors besser aus einer Messung herausgefiltert werden.

Durch die NVH-Messung, also die Körperschallmessung, lassen sich verschiedene Fehler innerhalb der elektrische Antriebseinheit identifizieren, z.B. Fehler innerhalb des Getriebes oder des Differenzials. Eine fehlerhafte elektrische Antriebseinheit "klingt" anders als eine fehlerfreie.

Das NVH-Messsystem besteht aus mehreren Schwingungssensoren, die auf die elektrische Antriebseinheit zugestellt werden, und den Körperschall der elektrischen Antriebseinheit erfassen.

Zudem ist im Abtriebsstrang ein sogenannter TAC-Sensor (Torsion Accelerometer) verbaut, welcher die Drehbeschleunigung im Abtriebsstrang erfasst. Über ein Mikrophon, welches in der Nähe der elektrischen Antriebseinheit fest in der Prüfvorrichtung verbaut ist, wird der Luftschall erfasst.

Zur Qualitätsbeurteilung der elektrischen Antriebseinheit werden zudem bevorzugt verschiedene physikalische Größen gemessen und beurteilt wie beispielsweise HVDC-Spannung, HVDC-Strom sowie Drehzahl und Drehmoment an den Abtriebsmotoren.

In Elektrofahrzeugen spielt die Geräuschentwicklung der elektrischen Antriebseinheit eine zentrale Rolle, da diese zum Fahrkomfort der Insassen beiträgt.

Neben der Geräuschanalyse während des Fahrbetriebs in Form von verschiedenen Drehmoment- und Drehzahlprofilen kann in der erfindungsgemäßen Prüfvorrichtung auch die Sensorik und Aktorik, welche für den Betrieb der elektrischen Antriebseinheit notwendig sind, überprüft werden.

Dies beinhaltet beispielweise die Überprüfung und das Anlernen des Rotorlagegeber-Sensors der elektrischen Antriebseinheit, welcher die Drehzahl des Elektromotors der elektrischen Antriebseinheit erfasst.

Zudem ist oftmals eine mechanische Parksperre innerhalb der elektrischen Antriebseinheit verbaut, welche im eingelegten Zustand eine Drehung der elektrischen Antriebseinheit und damit ein Wegrollen des Elektrofahrzeugs beim Parken verhindert. Die korrekte Funktion der Parksperre kann durch Betätigung der Parksperre und einer anschließenden Kraftbeaufschlagung auf die Abtriebswellen über die Abtriebsmotoren überprüft werden.

In der Prüfvorrichtung arbeitet die EDU entsprechend gegen diese Abtriebsmotoren, die in der Regel als Elektromotoren ausgebildet sind.

Das Antriebssystem der Prüfvorrichtung bildet die elektrische HVDC-Versorgung der elektrischen Antriebseinheit (DC-Quelle/Senke = Simulation der HV-Batterie im Elektrofahrzeug) und die Frequenzumrichter der Abtriebsmotoren, welche über einen gemeinsamen DC-Zwischenkreis miteinander und über eine gemeinsame Ein-/Rückspeiseeinheit und einen Trenntrafo mit dem Versorgungsnetz verbunden sind.

Dieses Antriebssystem sorgt dafür, dass die elektrische Antriebseinheit und die Abtriebsmotoren mit Spannung versorgt sind und verschiedene Fahrzustände realisieren können.

Hierbei arbeitet die elektrische Antriebseinheit meist drehmomentgeregelt, wohingegen die Abtriebe drehzahlgeregelt arbeiten und damit die Reibungsstärke der Räder und Straße simulieren.

Dieses Zusammenspiel erzeugt entsprechende Drehzahl- bzw. Drehmomentrampen an der elektrischen Antriebseinheit bzw. an den Abtriebsmotoren.

Besonders bevorzugt ist, wenn das Getriebe eine Getriebewelle umfasst, über die der Abtriebsmotor mit der Abtriebswelle gekoppelt ist. Zum einen lässt sich auf diese Weise über die Wahl des Übersetzungsverhältnisses eine besonders gute Entkopplung für die Geräuschanalyse bereitstellen. Auf der anderen Seite dient die Getriebewelle aber auch zur Festlegung der Drehzahl am Abtriebsmotor. Dabei können auf den Wellen Riemenscheiben zur Führung der Riemen vorgesehen sein, wobei ein Riemen zwischen Abtriebsmotor und Getriebewelle und ein Riemen zwischen Getriebewelle und Abtriebswelle vorgesehen sein kann. Das Riemengetriebe kann dabei eine Spanneinrichtung aufweisen, die insbesondere mit der Getriebewelle zusammenwirkt.

Alternativ ist auch ein Zahnradgetriebe denkbar, das den Vorteil der kompakten Bauart aufweist.

Eine besonders bevorzugte Gestaltung der Erfindung sieht vor, dass jeder Abtriebsmotor mit mindestens zwei bezüglich einer zugeordneten elektrischen Antriebseinheit gleichseitigen Abtriebswellen, die jeweils mit einer elektrischen Abtriebseinheit gekoppelt sind, verbunden ist. Durch diese Ausgestaltung kann ein sogenannter Doppeltakt realisiert werden.

Innerhalb einer Prüfvorrichtung (Prüfstand) werden im Gegensatz zum konventionellen Konzept zwei elektrische Antriebeinheiten parallel geprüft.

In dieser Prüfvorrichtung werden zwei elektrische Antriebeinheiten parallel zur Prüfung kontaktiert und gespannt. Damit ist ein paralleler Betrieb von zwei elektrischen Antriebeinheiten innerhalb einer Prüfvorrichtung möglich. Innerhalb einer konventionellen Prüfzeit-Länge können im besten Fall zwei elektrische Antriebeinheiten geprüft werden, was eine doppelte Ausbringung pro Prüfvorrichtung ermöglicht.

Damit sind für ein EOL-Prüffeld, in dem mehrere Prüfvorrichtungen platziert sind, um eine entsprechende Ausbringung zu erreichen, nur noch die Hälfe an Prüfvorrichtungen für dieselbe Ausbringung notwendig.

Dabei sind analog zum konventionellen Konzept zwei Abtriebsmotoren notwendig, hier allerdings zur Prüfung von zwei elektrischen Antriebeinheiten parallel. Die Leistungsdimensionierung dieser Abtriebsmotoren verdoppelt sich, da nun gegen zwei elektrische Antriebeinheiten gearbeitet und gegengehalten werden muss als konventionell nur gegen eine elektrische Antriebeinheit. Dennoch halbiert sich die Gesamtmenge an benötigten Abtriebsmotoren.

Dies hat auch Auswirkungen auf das gesamte Antriebssystem der Prüfvorrichtung, bestehend aus der DC-Quelle/Senke, den Frequenzumrichtern der Abtriebsmotoren, der Ein-/Rückspeiseeinheit und des Trenntrafos.

Die Beschaffungsmengen dieses Antriebssystems für ein EOL-Prüffeld halbieren sich, verdoppeln sich allerdings in der Leistungsdimensionierung. Nichtsdestotrotz gibt es dadurch einen wirtschaftlichen Vorteil, da die Kosten eines leistungsstärkeren Gesamt-Antriebssystems geringer ausfallen als zwei kleinere Einzel-Antriebssysteme.

Bevorzugt erfolgt die Drehmoment- und Drehzahlübertragung auf die Abtriebsmotoren über ein Riemengetriebe.

Damit kann für beide elektrische Antriebeinheiten dieselbe Drehzahl an den Abtriebssträngen eingeregelt werden. Die eingestellte Drehzahl ist daher für beide elektrischen Antriebeinheiten immer identisch. Die beiden elektrischen Antriebeinheiten müssen jedoch nicht zwingend dasselbe Drehmoment aufbringen, es sind parallel unterschiedliche Drehmomente möglich, allerdings immer beim gleichen DrehzahlBetriebspunkt. Weiter bevorzugt kann das Getriebe eine Übersetzung aufweisen, so dass der Betrieb im optimalen Bereich stattfinden kann.

Grundsätzlich sind auch mehr als zwei elektrische Antriebseinheiten gleichzeitig in der Prüfvorrichtung prüfbar. Der Aufwand bezüglich der Kopplung mit dem Abtriebsmotor ist dann jedoch erhöht und auch der Abtriesmotor muss entsprechend ausgelegt sein.

Es ist dabei bevorzugt, wenn jede der elektrischen Antriebseinheiten in einer separaten Aufnahme gehalten ist. Auf diese Weise sind beide zu prüfenden elektrischen Antriebseinheiten so weitgehend wie möglich entkoppelt, wobei insbesondere eine weitgehende Entkopplung der Akustik gewünscht ist, damit sich die Messungen der NVH-Prüfung nicht gegenseitig beeinflussen.

Zur Messung, Prüfung und/oder Simulation kann es vorgesehen sein, dass eine Steuerungseinrichtung und/oder einer Messwerterfassungs- und Auswerteeinheit vorgesehen sind.

Ferner kann vorgesehen sein, dass die Prüfvorrichtung eine Antriebseinrichtung aufweist, die die elektrische Antriebseinheit und die Abtriebsmotoren mit Spannung versorgt.

Bei der Ausgestaltung, mit mehreren zu prüfenden elektrischen Antriebseinheiten, die parallel geprüft werden, ist es besonders vorteilhaft, wenn die Abtriebsmotoren in Gebrauchslage unterhalb und/oder seitlich der Aufnahme angeordnet sind und insbesondere bei zwei mit einem Abtriebsmotor verbundenen Abtriebswellen mittig zwischen den Abtriebswellen vorgesehen ist. Unter mittig ist hierbei auch zu verstehen, wenn die Abtriebsmotoren in Gebrauchslage mittig zwischen zwei gleichseitigen Abtriebswellen, aber ggf. auch unterhalb dieser angeordnet sind. Jedoch auch bei einer zu prüfenden elektrischen Antriebseinheit ergeben sich Vorteile in der benötigten Fläche der Prüfvorrichtung. Insbesondere können die Abtriebsmotoren dann so angeordnet sein, dass sie nicht oder nicht wesentlich über die Abtriebswellen hinausragen.

Insbesondere bei der Vorsehung von zwei Aufnahmen ist zudem die Orientierung der Abtriebsmotoren innen zwischen den Aufnahmen möglich.

Durch die geringere Anzahl notwendiger Prüfvorrichtungen und die geringere Breite der Prüfvorrichtung wird ein kleinerer Footprint der Prüfvorrichtung und damit ein geringerer Flächenbedarf des EOL-Prüffeldes erreicht.

Aufgrund des geringeren Flächenbedarfs und der Reduzierung an notwendigen Prüfvorrichtungen wird zudem eine Reduzierung des Aufwandes zur Beschickung der Prüfvorrichtungen erreicht. Dies bedeutet, es werden weniger Transportbandstrecke, weniger Stopperpositionen sowie weniger Drehteller zur Transportrichtungssteuerung benötigt, welches die Kostenaufwände reduziert.

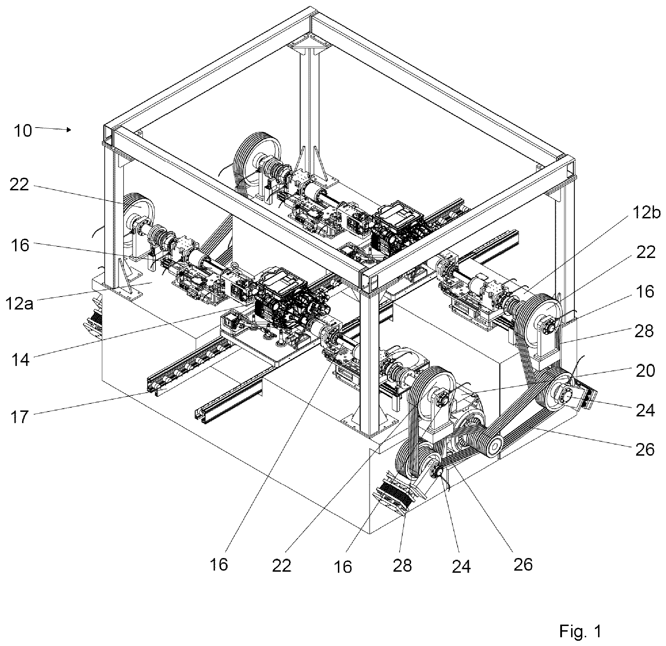

Eine Ausgestaltung der Erfindung ist in der beigefügten Zeichnung gezeigt, dabei zeigt Figur 1 eine Prüfvorrichtung mit dem Bezugszeichen 10 umfassend zwei Aufnahmen 12a und 12b für zwei zu prüfende elektrische Antriebseinheiten 14, wobei je elektrischer Antriebseinheit 14 beidseits Abtriebswellen 16 vorgesehen sind, über die die Anbindung an Räder eines Elektrofahrzeugs simuliert wird.

Darüber hinaus sind Zuführeinrichtungen 17 gezeigt, über die die elektrischen Antriebseinheiten 14 in die Prüfvorrichtung 10 eingebracht werden können.

Die jeweils auf einer Seite der elektrischen Antriebseinheit 14 vorgesehenen Abtriebswellen 16 sind jeweils mit einem Abtriebsmotor, wovon in der Zeichnungsdarstellung lediglich der rechte zu sehen ist und mit dem Bezugszeichen 20 bezeichnet ist, gekoppelt, über die die verschiedenen Prüf- und Simulationsprogramme gefahren werden.

Der Abtriebsmotor 20 ist über ein Riemengetriebe 22 mit der jeweiligen Abtriebswelle 16 gekoppelt, so dass zwei parallele Getriebe 22 je Abtriebsmotor 20 vorgesehen sind, die die elektrischen Antriebseinheiten 14 mit gleicher Drehzahl beaufschlagen.

Im vorliegenden Fall ist das Getriebe 22 als Riemengetriebe ausgebildet, wobei eine Getriebewelle 24 vorgesehen ist, die über einen ersten Riemen 26 mit dem Abtriebsmotor 20 gekoppelt ist und über einen zweiten Riemen 28 mit der jeweiligen Abtriebswelle 16.

Die Dimensionierung der Abtriebsmotoren erfolgt dabei so, dass für beide elektrischen Antriebseinheiten 14 dieselbe Drehzahl an den Abtriebswellen 16 eingeregelt werden kann. Die eingestellte Drehzahl ist dabei für beide elektrische Antriebseinheiten 14 immer identisch.

Grundsätzlich können die elektrischen Antriebseinheiten 14 parallel unterschiedliche Drehmomente aufbringen, bei jeweils gleichem Drehzahlbetriebspunkt.

Der besondere Vorteil liegt darin, dass die Baulänge in Längsrichtung L der Prüfvorrichtung 10 verkürzt werden kann, da die Abtriebsmotoren 20 nicht oder nur unwesentlich über die eigentlichen Aufnahmen 12a und 12b hinüberragen und zwischen diesen angeordnet sein können. Darüber hinaus erfolgt die Anordnung der Abtriebsmotoren 20 gegenüber den elektrischen Antriebseinheiten 14 in Gebrauchslage nach unten versetzt. Auf diese Weise kann eine platzsparendere Gestaltung der gesamten Prüfvorrichtung 10 erreicht werden.

Insbesondere für die vorgesehene NVH-Messung ist die Vorsehung eines Riemengetriebes, die eine weitergehende Entkopplung und ein besseres Herausfiltern der Geräusche der Abtriebsmotoren 20 ermöglicht, vorteilhaft. Damit sich die beiden elektrischen Antriebseinheiten 14 nicht geräuschtechnisch beeinflussen, sind die Aufnahmen 12a und 12b voneinander aktustisch entkoppelt, so dass eine NVH-Messung für jede der elektrischen Antriebseinheiten separat möglich ist.

Zusammengefasst ergeben sich folgende mögliche Vorteile bei der erfindungsgemäßen Prüfvorrichtung:
- Weniger Aufwände in der Steuerungs- und
   Automatisierungstechnik: Nur noch eine Vorrichtungs-Steuerung (SPS) und Bedienpanel für die
   Automatisierungssteuerung. Nur noch eine einfache statt doppelter Ausführung vieler
   Maschinensicherheitskomponenten wie Schutztüren, Ein- und Ausförderstrecken (Lichtgitter, Muting-Systemen etc.)
- Reduzierung von 2 Gesamt-Antriebssystemen auf 1 Gesamt-Antriebssystem mit größerer Dimensionierung

Zudem ergeben sich folgende Vorteile bezüglich der NVH-Messung während des Prüfablaufs:
Durch die Anbindung über ein Getriebe, insbesondere ein Riemengetriebe, zu den Abtriebsmotoren ergibt sich eine Entkopplung von den elektrischen Antriebseinheiten zu den Abtriebsmotoren im Abtriebsstrang. Dadurch werden die Einflüsse der Abtriebe mit Hilfe des bekannten Übersetzungsverhältnisses herausgefiltert und haben somit keinen Einfluss oder einen deutlich geringeren Einfluss auf die Geräuschanalyse des Prüflings, also der elektrischen Antriebseinheit, die mit Hilfe von Beschleunigungssensoren (z.B. Dreh-; Lineare- und 3D Sensoren) erfolgen kann.

## Patentansprüche

1. Prüfvorrichtung (10) für elektrische Antriebseinheiten umfassend eine Aufnahme (12a, b) für eine elektrischen Antriebseinheit (14) sowie zwei Abtriebswellen (16), die beidseits endseitig mit einer elektrischen Antriebseinheit (14) koppelbar sind, wobei die zwei Abtriebswellen (16) jeweils mit einem separaten Abtriebsmotor (20) gekoppelt sind, die die elektrischen Antriebseinheit (14) in einem motorischen Betrieb antreiben und/oder in einem generatorischen Betrieb belasten können, **dadurch gekennzeichnet, dass** jeder Abtriebsmotor (20) über ein Getriebe (22) mit der zugehörigen Abtriebswelle (16) gekoppelt ist.

2. Prüfvorrichtung (10) nach Anspruch 1, **dadurch gekennzeichnet, dass** es sich bei dem Getriebe (22) um ein Riemengetriebe handelt.

3. Prüfvorrichtung (10) nach Anspruch 1 oder 2, **dadurch gekennzeichnet, dass** das Getriebe (22) eine Getriebewelle (24) umfasst, über die der Abtriebsmotor (20) mit der Abtriebswelle (16) gekoppelt ist.

4. Prüfvorrichtung (10) nach einem der Ansprüche 1 bis 3, **dadurch gekennzeichnet, dass** jeder Abtriebsmotor (20) mit mindestens zwei bezüglich einer zugeordneten elektrischen Antriebseinheit (14) gleichseitigen Abtriebswellen (16), die jeweils mit einer elektrischen Antriebseinheit (14) gekoppelt sind, verbunden ist.

5. Prüfvorrichtung (10) nach Anspruch 4, **dadurch gekennzeichnet, dass** jede der elektrischen Antriebseinheiten (14) in einer separaten Aufnahme (12a, b) gehalten ist.

6. Prüfvorrichtung (10) nach einem der vorangehenden Ansprüche, **dadurch gekennzeichnet, dass** eine Steuerungseinrichtung und/oder einer Messwerterfassungs- und Auswerteeinheit vorgesehen sind.

7. Prüfvorrichtung (10) nach einem der vorangehenden Ansprüche, **dadurch gekennzeichnet, dass** die Prüfvorrichtung (10) eine Antriebseinrichtung aufweist, die die elektrische Antriebseinheit (14) und die Abtriebsmotoren (20) mit Spannung versorgt.

8. Prüfvorrichtung (10) nach einem der vorangehenden Ansprüche, **dadurch gekennzeichnet, dass** die Abtriebsmotoren (20) in Gebrauchslage unterhalb und/oder seitlich der Aufnahme (12) angeordnet sind und insbesondere bei zwei mit einem Abtriebsmotor (20) verbundenen Abtriebswellen (16) mittig zwischen den Abtriebswellen (16) vorgesehen ist, wobei die Abtriebsmotoren (20) besonders bevorzugt nicht wesentlich über die Aufnahmen (12a, b) hinausragt.

9. Prüfvorrichtung (10) nach einem der vorangehenden Ansprüche, **dadurch gekennzeichnet, dass** das Getriebe (22) eine Übersetzung aufweist.
